Europäisches Patentamt

European Patent Office

Office européen des brevets

(11) Veröffentlichungsnummer: **0 096 282**
**A2**

## (12) EUROPÄISCHE PATENTANMELDUNG

(21) Anmeldenummer: 83105095.0

(22) Anmeldetag: 24.05.83

(51) Int. Cl.³: **G 03 F 7/08**

(30) Priorität: 03.06.82 DE 3220816

(43) Veröffentlichungstag der Anmeldung:
21.12.83 Patentblatt 83/51

(84) Benannte Vertragsstaaten:
AT CH DE FR GB IT LI NL SE

(71) Anmelder: Merck Patent Gesellschaft mit beschränkter
Haftung
Frankfurter Strasse 250
D-6100 Darmstadt(DE)

(72) Erfinder: Haas, Günther, Dr.
Saarstrasse 109
D-6903 Neckargemünd(DE)

(72) Erfinder: Neisius, Karl Heinz, Dr.
Kattreinstrasse 76
D-6100 Darmstadt(DE)

(72) Erfinder: Stein, Alfred, Dr.
Grundstrasse 9
D-6100 Darmstadt(DE)

(54) Lichtempfindliche Komponenten für positiv arbeitende Fotoresistmaterialien.

(57) Lichtempfindliche Komponenten für positiv arbeitende Fotoresistmaterialien, die im wesentlichen aus Veresterungsprodukten von 2,3,4-Trihydroxybenzophenon mit 6-Diazo-5-oxo-5,6-dihydro-naphthalinsulfonsäure bestehen und dadurch gekennzeichnet sind, daß

a) die lichtempfindlichen Komponenten mindestens 80% an Gemischen von Mono-, Bis- und Trisveresterungsprodukten enthalten,

b) in diesen Gemischen 40 bis 85% Monoveresterungsprodukte und 60 bis 15% Bis- und Trisveresterungsprodukte vorliegen und

c) die Bis- und Trisveresterungsprodukte im Verhältnis 1 : 0,05 bis 1 : 3 zueinander vorliegen,

weisen eine hohe Lichtempfindlichkeit auf. Fotoresistmaterialien, die diese lichtempfindlichen Komponenten neben alkalilöslichen Harzen und gegebenenfalls weiteren Zusatzstoffen enthalten, zeichnen sich zusätzlich zur hohen Lichtempfindlichkeit durch gute Haftfestigkeit auf dem Substrat und ein hohes Auflösungsvermögen für feinste Strukturen in fotolithographischen Verfahren aus.

Merck Patent Gesellschaft
mit beschränkter Haftung

D a r m s t a d t


Lichtempfindliche Komponenten für positiv arbeitende
Fotoresistmaterialien


Die Erfindung betrifft spezielle lichtempfindliche
Komponenten für positiv arbeitende Fotoresistmaterialien, im wesentlichen bestehend aus Veresterungsprodukten von 2,3,4-Trihydroxybenzophenon
mit 6-Diazo-5-oxo-5,6-dihydro-naphthalinsulfonsäure,
die eine hohe Lichtempfindlichkeit besitzen und
somit besondere Vorteile beim Einsatz in Fotoresistmaterialien aufweisen.

Fotoresistmaterialien, die alkalilösliche Harze, beispielsweise Phenol-Formaldehydharzsysteme, zusammen
mit einer lichtempfindlichen Komponente, üblicherweise
vom Typ der Diazochinone, enthalten, sowie deren Eignung für die photomechanische Herstellung von Druckformen und in der Halbleiterfertigung sind seit langem
bekannt. Als lichtempfindliche Komponenten werden insbesondere Ester der Naphthochinon-1,2-diazid-5-sulfonsäure mit 2,3,4-Trihydroxybenzophenon beschrieben, deren Herstellung und Verwendbarkeit beispielsweise aus dem DBP 938 233, der DE-AS 1195 166 und den US-Patenten 3,148,983, 3,201,239 und 3,402,044 bekannt sind.

Es hat sich jedoch gezeigt, daß Fotoresistmaterialien, die diese Ester als lichtempfindliche Komponenten enthalten, die Anforderungen, die in der Praxis an derartige Materialien gestellt werden, nicht in ausreichendem Maße erfüllen. So weisen die bekannten Fotoresistmaterialien teilweise eine zu geringe Lichtempfindlichkeit auf, was relativ lange Belichtungszeiten bzw. hohe Belichtungsenergien erforderlich macht, teilweise ist die Löslichkeit des Fotoresistmaterials im Entwickler unerwünscht groß, was zu einem Schichtdickenverlust auch an den unbelichteten Stellen während des Entwicklungsprozesses führt.

Es bestand also die Aufgabe, die Lichtempfindlichkeit von Fotoresistmaterialien zu verbessern, ohne daß dabei die übrigen Eigenschaften dieser Materialien, wie beispielsweise Haftfestigkeit, mechanische Festigkeit, Resistenz gegenüber Ätzmitteln und Auflösungsvermögen, vermindert werden. Ferner sollte die Löslichkeit der Fotoresistmaterialien im Entwickler so gering sein, daß die Schichtdicke an den unbelichteten Stellen während des Entwicklungsvorgangs möglichst unverändert bleibt.

Diese Aufgabe wurde durch die vorliegende Erfindung gelöst.

Es wurde nun gefunden, daß man wesentlich lichtempfindlichere Fotoresistmaterialien, die zusätzlich eine äußerst geringe Löslichkeit im Entwicklersystem aufweisen, erhält, wenn man lichtempfindliche Komponenten einsetzt, die im wesentlichen aus Veresterungsprodukten von 2,3,4-Trihydroxybenzophenon mit 6-Diazo-
5-oxo-5,6-dihydro-naphthalinsulfonsäure bestehen und
dadurch gekennzeichnet sind, daß

a) die lichtempfindlichen Komponenten mindestens
   80 % an Gemischen von Mono-, Bis- und Trisveresterungsprodukten enthalten,

b) in diesen Gemischen 40 bis 85 % Monoveresterungsprodukte und 60 bis 15 % Bis- und Trisveresterungsprodukte vorliegen und

c) die Bis- und Trisveresterungsprodukte im Verhältnis 1 : 0,05 bis 1 : 3 zueinander vorliegen.

Sowohl Mono-, Bis- als auch Trisveresterungsprodukte
aus 2,3,4-Trihydroxybenzophenon und 6-Diazo-5-oxo-
5,6-dihydro-naphthalinsulfonsäurehalogenid sind bereits als lichtempfindliche Komponenten bekannt
(DBP 938 233, USP 3,148,983, USP 3,402,044). Diese Substanzen allein erfüllen jedoch nicht die in der Praxis,
speziell bei der Herstellung mikroelektronischer Bauelemente, gestellten Anforderungen. Die lichtempfindlichen Monoveresterungsprodukte verursachen eine
zu große Löslichkeit des unbelichteten Fotoresistsystems im Entwickler, wodurch Auflösungsvermögen, Kantenprofil und Kontrast verschlechtert werden. Bei Bis-
und Trisveresterungsprodukten ist für weite Anwendungsbereiche die Lichtempfindlichkeit zu gering. Auch
Gemische aus verschiedenen Veresterungsprodukten sind
bereits bekannt. So werden im US-Patent 3,148,983 ein
1 : 1- und ein 1 : 2-Gemisch aus Mono- und Bisveresterungsprodukt erwähnt. Ferner erhält man beim Arbeiten gemäß den Angaben zur Herstellung des Monoesters (4-Benzoyl-2,3-dihydroxyphenyl)-6-diazo-5,6-dihydro-5-oxo-
naphthalinsulfonat im DBP 938 233 (Kondensation
von äquimolaren Mengen 2,3,4-Trihydroxybenzophenon
und 6-Diazo-5-oxo-5,6-dihydro-naphthalinsulfonsäure-
chlorid in Dioxan in Gegenwart von Alkalicarbonaten
oder -hydrogencarbonaten) keineswegs nur diesen Monoester, sondern vielmehr auch ein Gemisch, das aber
nur etwa 60 - 68 % an Veresterungsprodukten insgesamt
enthält. Auch ein solches Gemisch erfüllt nicht die
hohen Anforderungen bezüglich Lichtempfindlichkeit,
Haftfestigkeit und Unlöslichkeit des unbelichteten
Gesamtsystems im Entwickler. Umso überraschender ist
es, daß die speziellen erfindungsgemäßen Produkte allen
diesen Anforderungen gerecht werden.

Gegenstand der Erfindung sind somit lichtempfindliche
Komponenten für positiv arbeitende Fotoresistmaterialien,
im wesentlichen bestehend aus Veresterungsprodukten von
2,3,4-Trihydroxybenzophenon mit 6-Diazo-5-oxo-5,6-dihydro-
naphthalinsulfonsäure, die dadurch gekennzeichnet sind,
daß

a) die lichtempfindlichen Komponenten mindestens
   80 % an Gemischen von Mono-, Bis- und Trisveresterungsprodukten enthalten,

b) in diesen Gemischen 40 bis 85 % Monoveresterungsprodukte und 60 bis 15 % Bis- und Trisveresterungsprodukte vorliegen und

c) die Bis- und Trisveresterungsprodukte im Verhältnis 1 : 0,05 bis 1 : 3 zueinander vorliegen.

Die erfindungsgemäßen lichtempfindlichen Komponenten
enthalten mindestens 80 %, vorzugsweise mindestens 85 %,
insbesondere mindestens 88 % an Gemischen von Mono-,
Bis- und Trisveresterungsprodukten. Daneben sind in der
Regel noch kleinere Mengen an nicht reagierten Ausgangssubstanzen vorhanden.

GSPHA21 I-ol

Die Gemische von Mono-, Bis- und Trisveresterungsprodukten setzen sich zu 40 bis 85 %, vorzugsweise zu 50 bis 75 %, aus Monoveresterungsprodukten und zu 60 bis 15 %, vorzugsweise 50 bis 25 %, aus Bis- und Trisveresterungsprodukten zusammen. Unter Monoveresterungsprodukten werden (4-Benzoyl-2,3-dihydroxyphenyl)-6-diazo-5,6-dihydro-5-oxo-naphthalinsulfonat, (3-Benzoyl-2,6-dihydroxyphenyl)-6-diazo-5,6-dihydro-5-oxo-naphthalinsulfonat und (2-Benzoyl-5;6-dihydroxyphenyl)-6-diazo-5,6-dihydro-5-oxo-naphthalinsulfonat verstanden. Bisveresterungsprodukte sind solche Verbindungen, in denen zwei der drei am 2,3,4-Trihydroxybenzophenon vorhandenen Hydroxygruppen mit einem 6-Diazo-5-oxo-5,6-dihydro-naphthalinsulfonsäurerest verestert sind. Im Trisveresterungsprodukt sind alle drei Hydroxygruppen des 2,3,4-Trihydroxybenzophenons mit einem 6-Diazo-5-oxo-5,6-dihydro-naphthalinsulfonsäurerest verestert.

Bis- und Trisveresterungsprodukte liegen im Verhältnis von 1 : 0,05 bis 1 : 3, vorzugsweise 1 : 0,1 bis 1 : 2, insbesondere 1 : 0,2 bis 1 : 0,8, zueinander vor.

Gegenstand der Erfindung ist ferner ein Verfahren zur Herstellung der erfindungsgemäßen lichtempfindlichen Komponenten, das dadurch gekennzeichnet ist, daß man die Veresterung von 2,3,4-Trihydroxybenzophenon mit 6-Diazo-5-oxo-5,6-dihydro-naphthalinsulfonsäurehalogenid in Gegenwart einer tertiären stickstoffhaltigen organischen Base als Kondensationsmittel durchführt.

Bei der Herstellung der erfindungsgemäßen lichtempfindlichen Komponenten setzt man als Ausgangsprodukt zweckmäßig das 6-Diazo-5-oxo-5,6-dihydro-
naphthalinsulfonsäurechlorid ein. In der Regel werden
die beiden Ausgangssubstanzen 2,3,4-Trihydroxybenzophenon und 6-Diazo-5-oxo-5,6-dihydro-naphthalinsulfon-
säurehalogenid im Molverhältnis 1 : 1 bis 3 : 1 eingesetzt.

Unter den tertiären stickstoffhaltigen organischen Basen sind Trialkylamine, worin die Alkylgruppen gleich
oder verschieden sein können und vorzugsweise 1 bis
8 C-Atome enthalten, beispielsweise Trimethyl-,
Triethyl-, Dimethyl-isopropyl-, Tri-n-butyl-amin;
alicyclische stickstoffhaltige Verbindungen wie
N-Alkylpiperidine oder N-Alkylpyrrolidine oder aromatische Verbindungen wie Pyridin, Mono- oder Dialkylpyridine, Chinoline, Isochinoline, Dialkylaniline
gut geeignet. Besonders bevorzugt sind Triethylamin,
Pyridin, Tri-n-butylamin und 2,6-Dimethylpyridin. Die
Base wird zweckmäßig in der gleichen Menge wie das
Sulfonsäurehalogenid zugesetzt, kann aber auch im Unter-
oder Überschuß verwendet werden.

Die Reaktion wird zweckmäßig in einem organischen
Lösungsmittel durchgeführt. In Frage kommen dabei beispielsweise niedere Alkohole wie Methanol, Ethanol;
Ketone wie Aceton, Methylethylketon; Ether wie Diethylether, Tetrahydrofuran; Ester wie Ethylacetat, Butylacetat.

Zur Durchführung der Reaktion wird das Kondensationsmittel, gegebenenfalls auch im Gemisch mit dem Sulfonsäurehalogenid oder dem 2,3,4-Trihydroxybenzophenon, langsam zu den übrigen Reaktionsteilnehmern zugegeben. Die Reaktionstemperatur liegt in der Regel zwischen -10° und +30°. Die Reaktion ist meist nach 2 bis 12 Stunden beendet. Zur Aufarbeitung des Reaktionsansatzes genügt es meistens, falls erforderlich Wasser oder einen niederen Alkohol zuzusetzen, das ausgefallene Reaktionsprodukt abzutrennen, zu waschen und zu trocknen. Die so erhaltenen Produkte sind in der Regel zur Verwendung als lichtempfindliche Komponenten in Fotoresistmaterialien unmittelbar geeignet. Sie können aber auch noch weiter aufgereinigt werden, zweckmäßig durch Umfällen. Dazu löst man sie in einem geeigneten Lösungsmittel, wie beispielsweise einem Keton oder Ether, und fällt sie durch anschließendes Zugeben von Wasser oder einem niederen Alkohol wieder aus.

Die Zusammensetzung der erhaltenen lichtempfindlichen Komponenten für positiv arbeitende Fotoresistmaterialien läßt sich mit üblichen Analysenmethoden, insbesondere mit Hilfe der Hochdruck-Flüssigkeitschromatographie, bestimmen.

Gegenstand der Erfindung sind ferner auch positiv arbeitende Fotoresistmaterialien, die dadurch gekennzeichnet sind, daß erfindungsgemäße lichtempfindliche Komponenten enthalten sind.

Gegenstand der Erfindung ist auch die Verwendung von erfindungsgemäßen lichtempfindlichen Komponenten zum Erzeugen von Abbildungen mit Hilfe von positiv arbeitenden Fotoresistmaterialien.

Positiv arbeitende Fotoresistmaterialien sind seit langem bekannt. Sie enthalten im wesentlichen mindestens ein alkalilösliches Harz und eine lichtempfindliche Komponente sowie gegebenenfalls weitere, in dieser Technologie bekannte und übliche Zusatzstoffe, die gemeinsam in einem Lösungsmittel oder
Lösungsmittelgemisch gelöst sind. Bei den Harzen
handelt es sich in der Regel um säurebeständige,
in Alkalien und organischen Lösungsmitteln lösliche
Harze mit einem mittleren Molekulargewicht von
3000 bis 20000, vorzugsweise 4000 bis 12000.
Besonders bevorzugt sind Phenol- bzw. Kresol-(Form)
aldehydharzsysteme, die in bekannter Weise durch
Umsetzung von Aldehyden, insbesondere Formaldehyd, mit
einem Phenol in saurer oder alkalischer Lösung hergestellt werden können. Zur Herstellung der Harze können
die verschiedensten Phenole oder phenolische Verbindungen
verwendet werden, insbesondere solche mit 2 oder 3
reaktionsfähigen aromatischen Ringwasserstoffatomen.
Anstelle eines Aldehydes können auch Aldehyde freisetzende Verbindungen verwendet werden, die zu einer
Phenol-Aldehydkondensation befähigt sind. Beispiele
für besonders geeignete Phenole oder phenolische Verbindungen, die zur Herstellung von erfindungsgemäß verwendbaren Harzen verwendet werden können sind:
Kresol, Xylol, Ethylphenol, Butylphenol, Isopropylmethoxyphenol, Chlorphenol, Resorcin, Hydrochinon,
Naphthol, 2,2-Bis(p-hydroxyphenyl)propan. Beispiele
für geeignete Aldehyde sind außer Formaldehyd Acetaldehyd, Acrolein, Crotonaldehyd und Furfural. Ein Beispiel
für eine Aldehyd freisetzende Verbindung ist das 1,3,5-
Trioxan. Besonders brauchbare, alkalische Harze sind
beispielsweise Phenol-Formaldehyd-Novolakharze, Kresol-
Formaldehyd-Novolakharze, p-tert.Butylphenol-Formal-
dehyd-Novolakharze, phenolmodifizierte Xylol-Formal-
dehyd-Harze. Ferner kommen beispielsweise auch
Vinylacetat-, Vinylpyrrolidon-, Celluloseacetat-,
Urethan-, Epoxi- und Acrylatharze, ferner Mischpolymerisate, beispielsweise aus Styrol und ungesättigten
Carbonsäuren, in Frage.

Das Verhältnis von lichtempfindlicher Komponente zu alkalilöslichem Harz liegt im allgemeinen im Bereich von 1 : 1 bis 1 : 10, vorzugsweise 1 : 2 bis 1 : 5. Die Fotoresistmaterialien können außerdem weitere, in dieser Technologie bekannte und übliche Zusatzstoffe enthalten. Als Beispiele seien Füllstoffe, Farbstoffe, Pigmente, Weichmacher, Haftvermittler, thermisch aktivierbare, freie Radikale bildende Initiatoren genannt, ferner auch die verschiedensten anderen Polymeren und Harze, Stabilisatoren sowie oberflächenaktive Verbindungen, die gegebenenfalls zur Verbesserung der filmbildenden Eigenschaften oder Beschichtungseigenschaften beitragen können und/oder zur Verbesserung der Haftung der auf die Substrate aufgetragenen Schichten, ferner zur Verbesserung der mechanischen Festigkeit, der chemischen Widerstandsfähigkeit, der Fließbeständigkeit des Materials, aber auch zur Beeinflussung der Viskosität der Fotoresistmaterialien Solche Zusatzstoffe können in einer Menge von 0 bis 15 Gew.%, bezogen auf den Feststoffgehalt, zugesetzt werden.

Als Lösungsmittel, die die vorgenannten Bestandteile der Fotoresistmaterialien lösen können, eignen sich beispielsweise Ethylenglykol, Glykolether wie Glykolmonomethylether, Glykoldimethylether und Glykolmonoethylether; aliphatische Ester wie Ethylacetat, Hydroxyethylacetat, Alkoxyethylacetat, n-Butylacetat oder Amylacetat; Ether wie Dioxan; Ketone wie Methylethylketon, Methyl-isobutylketon und Cyclohexanon; Dimethylformamid, Xylol und Mischungen solcher Lösungsmittel. Diese Lösungen enthalten in der Regel 10 bis 60 %, vorzugsweise bis 50 % an Feststoffen. Als Substraten eignen sich an der Oberfläche thermisch oxidierte Siliziummaterialien, die gegebenenfalls auch dotiert sein können, ferner alle anderen, in der Halbleitertechnologie üblichen Substrate wie z.B. Siliziumnitrid, Galliumarsenid, Indiumphosphat, Metallplatten und -folien, beispielsweise aus Aluminium, Kupfer, Zink; Bimetall- und Trimetallfolien, aber auch elektrisch nicht leitende Folien, die mit Metallen bedampft sind, Glas, $SiO_2$-Materialien, Papier. Diese Substrate können einer Temperatur-Vorbehandlung unterzogen werden, oberflächlich angerauht, angeätzt oder zur Erhöhung der Hydrophilie mit Chemikalien behandelt sein.

Die Fotoresistschichen können in verschiedener Stärke auf ein Substrat aufgetragen werden. Die im Einzelfalle vorteilhafteste Schichtstärke hängt von verschiedenen Faktoren ab, beispielsweise dem speziellen Verwendungszweck des herzustellenden Materials, dem im Einzelfalle verwendeten Harz und der Natur der anderen Komponenten, die gegebenenfalls in der lichtempfindlichen Schicht zugegen sein können. Als zweckmäßig hat es sich in der Regel erwiesen, wenn die Resistschichten ein Stärke von 0,5 µm bis 3 µm aufweisen.

Der Auftrag der Fotoresistmaterialien auf die saubere, Oberfläche der Substrate kann durch Aufsprühen, Fließbeschichten, Walzen, Schleuderbeschichten und Tauchbeschichten erfolgen, wonach das Lösungsmittel durch Verdampfen entfernt wird, so daß auf der Oberfläche des Substrats eine lichtempfindliche Schicht zurückbleibt. Die Entfernung des Lösungsmittels kann gegebenenfalle durch Erhitzen der Schicht auf Temperaturen von bis zu 120° gefördert werden. Darauf-

GSPBA21 I-ol

hin wird die Fotoresistschicht der Strahlung ausgesetzt, welche die Reaktion der lichtempfindlichen Schicht verursacht. Üblicherweise wird aktinisches Licht verwendet, aber auch energiereiche Strahlung wie Röntgen- oder Elektronenstrahlung. Die Bestrahlung oder Belichtung kann durch eine Maskenvorlage durchgeführt werden, es kann aber auch ein gebündelter Strahl der Strahlung über die Oberfläche der lichtempfindlichen Resistschicht geführt werden. In der Schicht wird ein Bildmuster unter Freilegung von Teilen des Substrats entwickelt, indem die Schicht mit einer Entwicklerlösung behandelt wird, die im Falle der positiv arbeitenden Fotoresists die bestrahlten Bereiche des Resistmaterials entfernt. Als Entwicklerlösung wird in der Regel eine wäßrige schwach alkalische Lösung angewendet, beispielsweise eine wäßrige Alkalisilikat-, -metasilikat-, -phosphat-, -hydrogenphosphat-, -hydrogencarbonat-, oder -carbonat-Lösung oder eine organische Base wie Dialkanolamine. Anschließend wird das entwickelte Reliefbild mit destilliertem Wasser gespült und getrocknet. Um die Eigenschaften der verbleibenden Anteile der Fototresistschicht zu verbessern, wie ihr Haftvermögen gegenüber verschiedenen Substraten oder ihre Widerstandsfähigkeit gegenüber chemischen und/oder thermischem Abbau, wird die in Form des Musters vorliegende Fotoresistschicht üblicherweise bei erhöhter Temperatur gehärtet. Das Substrat kann dann geätzt werden, beispielsweise durch eine saure Ätzlösung.

Mit Hilfe der erfindungsgemäßen lichtempfindlichen Komponenten erhält man Fotoresistmaterialien von hoher Lichtempfindlichkeit, mit guten Haftungseigenschaften, die sich mit gleichförmiger Oberfläche auf Substrate auftragen lassen. Diese Materialien gestatten die Auflösung feinster Strukturen durch fotolithographische Verfahren und finden in der Druck- und Halbleitertechnik, insbesondere für miniaturisierte integrierte elektrische Schaltungen, und andere elektronische Bauteile, Verwendung.

Die folgenden Beispiele erläutern die Herstellung von erfindungsgemäßen lichtempfindlichen Komponenten sowie ihre Anwendung.

Beispiel 1

Zu einer Mischung von 63 g 6-Diazo-5-oxo-5,6-dihydro-naphthalinsulfonsäurechlorid und 54 g 2,3,4-Trihydroxybenzophenon in 600 ml Methanol gibt man im Verlauf von einer Stunde unter Eiskühlung eine Lösung von 27 g Triethylamin in 50 ml Methanol. Anschließend rührt man noch 3 Stunden bei Raumtemperatur. Der ausgeschiedene, ockergelbe Festkörper wird durch Filtration isoliert, mit Wasser gewaschen und getrocknet.

Die Zusammensetzung des erhaltenen Produktes wird mit Hilfe der Hochdruck-Flüssigkeitschromatographie (feste Phase: oberflächenmodifiziertes Kieselgel; mobile Phase: Acetonitril/Wasser 1 : 1) bestimmt:

Gehalt an Mono-, Bis- und Trisveresterungsprodukten: 89 %
davon Monoveresterungsprodukte: 42,6
       Bis- und Trisveresterungsprodukte: 57,4 %
Bisveresterungsprodukte: Trisveresterungsprodukt 1: 0,7.

Beispiel 2

Zu einer Lösung von 103,5 g 2,3,4-Trihydroxybenzophenon in 500 ml Aceton gibt man unter Eiskühlung langsam eine Lösung von 40,3 g 6-Diazo-5-oxo-5,6-dihydronaphthalin-sulfonsäurechlorid und 11,8 g Pyridin in 300 ml Aceton. Nach zwei Stunden wird die Reaktionsmischung in Wasser eingerührt. Dabei scheidet sich ein zähes Öl ab, das nach einiger Zeit erstarrt. Dieser Feststoff wird durch Filtration isoliert, in Aceton gelöst und aus Methanol ausgefällt. Man erhält eine ockergelbe, kristalline Substanz, die durch Filtration isoliert und anschließend getrocknet wird.

Zusammensetzung des erhaltenen Produktes (wie in Beispiel 1 bestimmt):

Gehalt an Mono-, Bis- und Trisveresterungsprodukten: 86,2 %
davon Monoveresterungsprodukte: 79,9 %
        Bis- und Trisveresterungsprodukte: 20,1 %
  Bisveresterungsprodukte: Trisveresterungsprodukt 1: 0,27

Beispiel 3

Zu einer Lösung von 103,5 g 2,3,4-Trihydroxybenzophenon und 35,6 g Pyridin in 500 ml Aceton wird unter Eiskühlung eine Lösung von 40,3 g 6-Diazo-5-oxo-5,6-dihydronaphthalinsulfonsäurechlorid in 200 ml Aceton zugetropft. Anschließend wird das Produkt durch Zugabe von Wasser als klebriger Feststoff ausgefällt, in Aceton gelöst, die Lösung wird über Aktivkohle filtriert und in Methanol eingerührt. Der ausgefallene ockergelbe Feststoff wird abfiltriert und getrocknet.

GSPHA21 I-ol

Zusammensetzung des erhaltenen Produktes (wie in
Beispiel 1 bestimmt):

Gehalt an Mono-, Bis- und Trisveresterungsprodukten: 89,2 %
davon Monoveresterungsprodukte: 46,6 %
          Bis- und Trisveresterungsprodukte: 53,4 %
Bisveresterungsprodukte: Trisveresterungsprodukt 1: 1,3.

Beispiel 4

Zu einer Lösung von 103,5 g 2,3,4-Trihydroxybenzophenon
und 11,8 g Pyridin in 500 ml Aceton wird unter Eiskühlung
eine Lösung von 40,3 g 6-Diazo-5-oxo-5,6-dihydro-
naphthalinsulfonsäurechlorid in 200 ml Aceton zugegeben.
Nach zwei Stunden wird die Reaktionsmischung in Wasser
eingerührt. Das ausgefallene Produkt wird abfiltriert,
mit Wasser gewaschen und getrocknet. Anschließend wird
das getrocknete Produkt in Methyl-tert.butyl-ether
suspendiert, die ungelöst verbleibenden Teile werden
abfiltriert. Nach dem Trocknen erhält man ein hellbraunes Kristallpulver.

Zusammensetzung des erhaltenen Produktes (wie in
Beispiel 1 bestimmt):

Gehalt an Mono- Bis- und Trisveresterungsprodukten: 80,0 %
davon Monoveresterungsprodukte: 80,4 %
          Bis- und Trisveresterungsprodukte: 19,6 %
Bisveresterungsprodukte: Trisveresterungsprodukt 1: 0,18.

Beispiele für Fotoresistmaterialien, die erfindungsgemäße lichtempfindliche Komponenten enthalten:

Beispiel 5

35 g der nach Beispiel 1 erhaltenen lichtempfindlichen
Komponente werden zusammen mit 125 g eines Kresolformaldehydharzes (mittleres Molekulargewicht 5500) in 340 ml
2-Ethoxyethylacetat bei Raumtemperatur gelöst.

Nach Filtration ist das Material gebrauchsfertig.
Der Fotoresist wird durch Aufschleudern auf oberflächlich thermisch oxidierte Silizium-Wafer in
1 µm dicker Schicht aufgetragen. Nach 30 minütigem
Vortrocknen bei 90° werden die Wafer im Kontaktbelichtungsverfahren durch eine Maske (Strichmuster)
belichtet. Nach der Belichtung werden die Wafer
35 Sekunden lang bei Raumtemperatur mit einer
wäßrigen, schwach alkalischen Entwicklerlösung auf
Basis Silikat-Phosphat im Tauchverfahren entwickelt.

Eine sehr niedrige Belichtungsenergie reicht bereits
aus, um den Fotoresist an den belichteten Stellen unter
dem oben definierten Entwicklungsbedingungen vollständig
vom Substrat abzulösen.

Beispiel 6

Analog Beispiel 5 wird ein Fotoresist hergestellt,
wobei jedoch als lichtempfindliche Komponente
35 g des nach Beispiel 3 erhaltenen Produktes
eingesetzt werden.

Beispiele 7 und 8

Analog Beispiel 5 wird ein Fotoresist hergestellt, wobei
jedoch als lichtempfindliche Komponente jeweils 35 g der
nach den Beispielen 2 und 4 erhaltenen Produkte und als

GSPHA21 I-ol

Harzbestandteil jeweils 125 g eines Kresolformaldehydharzes mit einem mittleren Molekulargewicht von 9000 eingesetzt werden.

Beispiel 9

23 g der nach Beispiel 1 erhaltenen lichtempfindlichen Komponente werden zusammen mit 9,2 g eines Phenolformaldehydharzes (mittleres Molekulargewicht 6000) in 37,2 ml Glykolmonoethylether bei 20 $^{\circ}$ gelöst. Nach Filtration ist das Fotoresistmaterial gebrauchsfertig.

Beispiel 10

11,0 g der nach Beispiel 3 erhaltenen lichtempfindlichen Komponente werden zusammen mit 34,1 g eines p-tert. Butylphenolformaldehydharzes (mittleres Molekulargewicht 4000) in 53 ml eines Gemisches aus Ethoxymethylacetat/Ethylenglykoldimethylether (1 : 1) bei 20 $^{\circ}$ gelöst. Nach Filtration ist das Fotoresistmaterial gebrauchsfertig.

Beispiel 11

10,3 g einer lichtempfindlichen Komponente mit der folgenden Zusammensetzung:

Gehalt an Mono-, Bis- und Trisveresterungsprodukten: 83,4 % davon Monoveresterungsprodukte: 58,4 %
      Bis- und Trisveresterungsprodukte: 41,6 %
Bisveresterungsprodukte: Trisveresterungsprodukt : 1 : 0,51

werden zusammen mit 35 g eines Kresolformaldehydharzes (mittleres Molekulargewicht 5500) in 100,6 ml Ethoxyethylacetat bei 20 °C gelöst. Nach Filtration ist das Fotoresistmaterial gebrauchsfertig.

- 17 -                    0096282

Beispiel 12

Es wird ein Fotoresistmaterial hergestellt wie in
Beispiel 11 beschrieben, wobei jedoch 10,3 g einer
lichtempfindlichen Komponente mit der folgenden Zusammensetzung verwendet wird:

Gehalt an Mono-, Bis- und Trisveresterungsprodukten 85,3 %
davon Monoveresterungsprodukte: 51,5 %
    Bis- und Trisveresterungsprodukte: 48,5 %
Bisveresterungsprodukte: Trisveresterungsprodukte: 1 : 0,59.

Beispiel 13

Analog Beispiel 11 wird ein Fototresistmaterial hergestellt, wobei jedoch 10,3 g einer lichtempfindlichen
Komponente eingesetzt wird, die die folgende Zusammensetzung aufweist:

Gehalt an Mono-, Bis- und Trisveresterungsprodukten 81,5 %
davon Monoveresterungsprodukte: 65,4 %
    Bis- und Trisveresterungsprodukte: 34,6 %
Bisveresterungsprodukte: Trisveresterungsprodukte: 1 : 0,4.

GSPHA21 I-ol

Merck Patent Gesellschaft
mit beschränkter Haftung

D a r m s t a d t


Patentansprüche

1. Lichtempfindliche Komponenten für positiv arbeitende Fotoresistmaterialien, im wesentlichen bestehend aus Veresterungsprodukten von 2,3,4-Trihydroxybenzophenon mit 6-Diazo-5-oxo-5,6-dihydro-naphthalinsulfonsäure, dadurch gekennzeichnet, daß

a) die lichtempfindlichen Komponenten mindestens 80 % an Gemischen von Mono-, Bis- und Trisveresterungsprodukten enthalten,

b) in diesen Gemischen 40 bis 85 % Monoveresterungsprodukte und 60 bis 15 % Bis- und Trisveresterungprodukte vorliegen und

c) die Bis- und Trisveresterungsprodukte im Verhältnis 1 : 0,05 bis 1 : 3 zueinander vorliegen.

**0096282**

2. Verfahren zur Herstellung von lichtempfindlichen Komponenten nach Anspruch 1, dadurch gekennzeichnet, daß man die Veresterung von 2,3,4-Trihydroxybenzophenon mit 6-Diazo-5-oxo-5,6-dihydro-naphthalinsulfonsäurehalogenid in Gegenwart einer tertiären stickstoffhaltigen organischen Base als Kondensationsmittel durchführt.

3. Positiv arbeitende Fotoresistmaterialien, dadurch gekennzeichnet, daß lichtempfindliche Komponenten nach Anspruch 1 enthalten sind.

4. Verwendung von lichtempfindlichen Komponenten nach Anspruch 1 zum Erzeugen von Abbildungen mit Hilfe von positiv arbeitenden Fotoresistmaterialien.